Europäisches Patentamt

European Patent Office

Office européen des brevets

(11) Publication number: **0 418 448 A1**

## EUROPEAN PATENT APPLICATION

(21) Application number: 89500093.3

(51) Int. Cl.⁵: **G06F 1/00, G11C 5/00**

(22) Date of filing: 22.09.89

(43) Date of publication of application:
27.03.91 Bulletin 91/13

(84) Designated Contracting States:
AT BE CH DE FR GB IT LI LU NL SE

(71) Applicant: COMPUTERS IBERICA S.A.
Acacia, 5
E-28850 Torrejon de Ardoz Madrid(ES)

(72) Inventor: Bradshaw, J.
Computers Ibérica S.A Acacia 5 Poligono Industrial
ES-28850 Torrejon de Ardoz(Madrid)(ES)

(74) Representative: Lahidalga de Careaga, Jose Luis
Goya, 143
E-28009 Madrid(ES)

(54) **A system for the protection against mains supply failure for computers by storing the processed information held in the volatile memory.**

(57) An internal protection system against line input failures for computers which allows the information held in the memory at the time of the mains failure to be saved to hard disc. The system consists of a mains failure detection system which activates a converter powered by an accumulator to supply the necessary 280 Volts D.C. required by a conventional switching power supply and which, furthermore, also activates a programme,via an NMI previously stored in ROM to save all information in the memory to hard disk.

FIG 1

a) A system for the protection against mains supply failure for computers by storing the processed information hel in the volatile memory.

b) The invention relates to the field of computers and specifically to that of HARDWARE, that is to those inventions which refer to important improvements to their components and a better performance and simplification in their use or in the execution of certain types of functions which were not possible with previous technology.

c) The state of technology at this moment is characterized by the rapid development of reliability, versatility and reduction in costs of the end product. Also great advances have been made by using faster and more complex microprocessors. But even so, there remain some important problems to be solved. One of the most important arises from the present non-existence of any micro computer that has incorporated within itself a system of protection against cuts in the input source which, unfortunately, all-too-often causes the loss of the information held, at the time, in the memory and in many cases irreparable damage to the reading or writing heads of disks and to the surfaces of the same.

Until now, to solve this problem it was necessary to adquire large and costly external input systems known as U.P.U. (Uninterruptible Power Supply) the purpose of which was to warne the operator of abnormalities and start a process of input using accumulators and of course functioning during a limited period.

These devices have major drawbacks such as:
- excessive occupation of space
- geater cost
- it demands the presence of the operator to save the information
- A large such systema is needed for each micro computer or one for a limited number of systems with sucdesive adquisitons of ever greater power according to the increase in the number of systems for the installation.

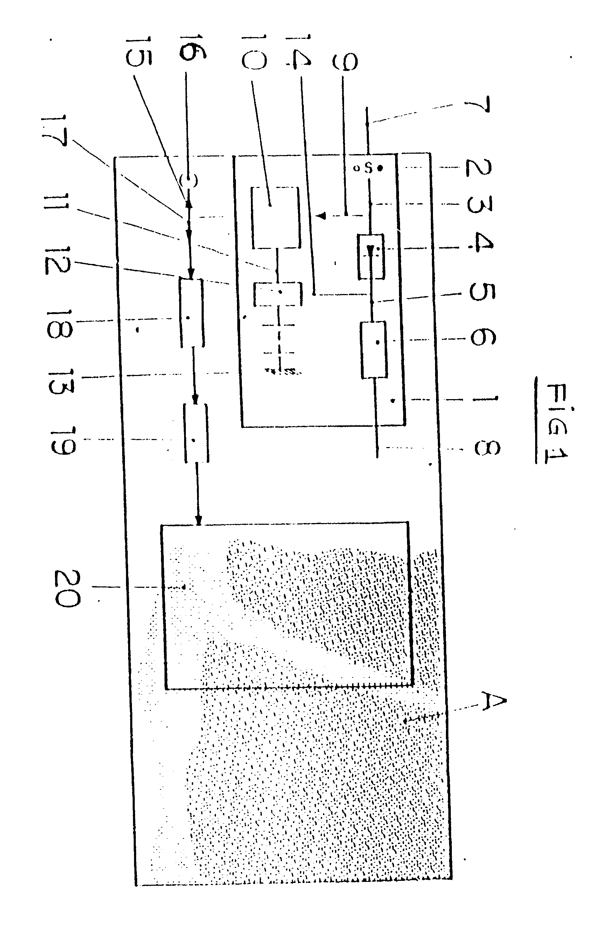

d,e) Having described the state of the technology prior to the invention we propose, we will detail the new invention first briefly describing the elements of the drawing which supports the said invention.

In the said page of drawings we distinguish:

A.- Body of the C.P.U.
1.- Input source of the computer, in which elements 2,3,4,5,6,7,8,9 and 14 are distinguished.
7.- Entry point of alternate current to the input source.
2.- Entry connector, for usual alternate current.
3.- Transmission cable to the rectifier, from which leaves the shunt -9-.

4.- Rectifier that converts the usual alternate current of 110/220v to 280v.
5.- Transmission connection to the regulator.
6.- Input source regulator.
8.- Current exit from the input source.
9.- Cable of the detector which joing the entry connection to the system fault.
10.- Relay systems fault detector.
11.- Communicator to the converter.
12.- 12v. to 280v. converter.
13.- 12v. accumulator.
14.- Exit of 280v. current.
15.- Exit of the warning to the operator.
16.- Means of warning the aparatus operator.
17.- Order connection of the detector to the chip with the adequate R.O.M.
18.- Chip in R.O.M. memory programmed to execute a dumping order.
19.- Information in the memory.
20.- Hard disk for storing the saved information.

In Accordance with this outline description of the drawings, we shall see its components and its operation.

So, having seen the state of the previous technology and the unsolved problems we will see the way in which they are solved in accordance with the following description. In principle we have a normal input source of any computer which is formed by:

Entry of the alternate current of 110/220v -7-, entering via a connector -2- that communicates by means of the appropiate cable with the rectifier from which flows the 280v current which is that which satisfies the needs of the computer.

This is the plan followed by any input source.

Now we will see what happens when an input fault occurs. This is detected by a connector placed in the entry connector -9- that transmits the information to the system fault detector relay -10- that communicates via -11- with a converter -12- that is fed by an accumulator -13- of 12v that it converts to 280v which by the connector -14- to the cable -3-joins the rectifier to the regulator and therefore incorporates the same current of 280v.

This simple device placed in the interior and together with the input source radically puts an end to the problem of occupation of outside space and there do not exist problems with the number of systems that are incoporated in the installation.

But this is only a part of the device, for the other problem that existed when there was a cut in the power supply and was that which relates to the information that was being processed, it also has its saving procedure which basically consists of the following:

When there occurs a cut in the power supply we have already seen how the current is restored and that two commands are emitted from the detector -10-, one via the connector -15-to the warning signal to the operator -21-, so that he/she knows that there is a problems and that he/she has a limited time in which to solve it; and another via connector -17-to the software in the R.O.M. memory stored in a chip -18-and that causes the execution of the order for the dumping of the information contained in the memory -19- to the appropriate hard disk -20-.

In this manner another very important problem is also solved that of the saving of the information in the R.O.M. memory.

f) A means of realization of the invention is already broadly described in the previous description.

g) The invention is capable of industrial application in a manner that is evident in relation to the description, and having made this description it is necessary to add that the details of the realization of the idea in question can vary, without changing the essence of the invention which is that which is shown in the above paragraphs and is claimed in the following note.

## Claims

1st.- A system for the protection against mains supply failure for computers by storing the processed information held in the volatile memory, essencially distinguished because the C.P.U. -A- contins a system fault detector relay -10- joined via a universal connector -9- to the connector -12- at the entry of an input source -1- of the C. P. U. -A- of a computer, with the said relay -10- being joined by another universal connector -11- to an electronic converter -12- that runs off a small accumulator -13- converting the current from the accumulator -13- from 12v to 280v, which is the current incorporated into the connector -5- that joins the rectifier -4- of the input source -1- to the regulator -6- of the same source, thus when there is a fault in the current which enters through -7- it is detected by the relay -10- which activates the alternative input source -13- and converter -12- system.

2nd.- A system for the protection against mains supply failure for computers by storing the processed information held in the volatile memory, essentially distinguished by the 1st. claim and also because when the detection relay -10- detects a current fault emits two orders, one through the connector -15- to a luminous and acoustic signal -21- installed in the C.P.U. -A- and another order via the connector -17- to a chip -18- that in R.O.M. memory has a built-in soft-ware that executes the order of dumping the contents of the memory -19- which is the information being worked on into the hard disk -20- where it is stored.

Fig 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | ELEKTOR, vol. 8, nos. 7/8, July-August 1982, Canterbury, Kent, GB; "Power failure protection" <br> * Whole document * | 1 | G 06 F 1/00 <br> G 11 C 5/00 |
| A | EP-A-0 219 617 (MITSUBISHI DENKI K.K.) <br> * Abstract; figure 3 * | 1 | |
| A | US-A-4 763 333 (BYRD) <br> * Abstract; figures 2,3 * | 1,2 | |
| A | US-A-4 381 457 (WILES) <br> * Abstract; figure 1 * | 1,2 | |
| A | EP-A-0 167 322 (AMPEX CORP.) <br> * Abstract; figure 1; page 1, line 1 - page 4, line 3 * | 1,2 | |
| A | IBM TECHNICAL DISCLOSURE BULLETIN, vol. 17, no. 5, October 1974, pages 1449-1450, New York, US; R.O. HIPPERT et al.: "Saving random-access memory in the event of a power failure" <br> * Whole document * | 1,2 | TECHNICAL FIELDS SEARCHED (Int. Cl.5) <br><br> G 06 F <br> G 11 C |

The present search report has been drawn up for all claims

| Place of search | Date of completion of the search | Examiner |
|---|---|---|
| THE HAGUE | 16-05-1990 | ABSALOM R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)